# FASCICULE DE BREVET EUROPEEN

(11) **EP 2 533 285 B1**
(45) Date de publication et mention de la délivrance du brevet: **23.01.2019**
(21) Numéro de dépôt: 12171123.8
(22) Date de dépôt: 07.06.2012
(51) Int. Cl.: H01L 23/40, H01L 25/11, H01L 23/051, H02M 7/00, H01L 23/473

(54) **Pile de composants électroniques maintenus suivant un empilement pressé**
Stapel elektronischer Komponenten in einer komprimierten Stapelanordnung
Stack of electronic components held in a pressed stack

(30) Priorité: 10.06.2011 FR 1155101
(43) Date de publication de la demande: 12.12.2012
(73) Titulaire: GE Energy Power Conversion Technology Limited, Rugby Warwickshire CV21 1BU (GB)
(72) Inventeur: Baerd, Henri, 77430 Champagne sur Seine (FR); Renaud, Guillaume, 91300 Massy (FR)
(74) Mandataire: Serjeants LLP

(56) Documents cités:
- EP-A1- 2 056 441
- EP-A1- 2 161 745
- WO-A2-2004/028748
- JP-A- 8 037 198
- US-A- 3 936 704

## Description

La présente invention concerne une pile de composants électroniques maintenus suivant un empilement pressé du type comportant :
- des composants électroniques empilés suivant un axe d'empilement ;
- deux brides d'extrémité reliées l'une à l'autre par au moins deux tirants s'étendant parallèlement à l'axe d'empilement des composants, l'empilement des composants étant maintenu pressé entre les deux brides d'extrémité.

Dans les installations électriques de très haute puissance, il est connu d'associer en série plusieurs composants électroniques tels que des transistors de type IGBT et/ou des diodes ou encore des composants résistifs linéaires ou non linéaires.

Ces éléments sont maintenus empilés et comprimés sous une pression de plusieurs tonnes selon un axe d'empilement longitudinal. Ces ensembles formant des modules de puissance sont communément désignés sous le nom anglais de « press-pack » ou « pile » en français.

Une pile comporte généralement plusieurs composants électroniques de puissance, chacun sous forme d'une galette cylindrique comportant deux surfaces planes circulaires opposées s'étendant parallèlement l'une à l'autre transversalement à l'axe d'empilement longitudinal. Des circuits de refroidissement sont généralement agencés de part et d'autre de chaque composant à semi-conducteurs selon l'axe de la pile.

Dans la pile, un alignement central des composants électroniques et des circuits de refroidissement est requis.

Il est connu d'assurer cet alignement notamment grâce à un élément de guidage portant chaque composant à semi-conducteurs, cet élément de guidage étant en appui sur les tirants de la pile pour le maintien en position du composant.

Cet élément de guidage est couramment appelé sucette et est réalisé en matière plastique. Il ne contribue pas à la rigidité de l'ensemble de la pile et ne sert qu'à assurer un positionnement initial du composant à semi-conducteurs qu'il porte, avant mise sous pression de la pile.

La longueur des piles est actuellement limitée à une dizaine de composants à semi-conducteurs. Cette limitation en longueur est principalement dépendante de la rigidité de l'empilement des composants. En effet, lors de l'accroissement du nombre de composants empilés, un phénomène de flambage apparaît dans la pile, conduisant à de mauvaises répartitions de pression entre les composants pressés.

Il est donc nécessaire de limiter la longueur des piles pour éviter ce phénomène.

Il est d'usage de prévoir une pile par sous-circuit constitué de composants disposés en série. Ainsi, pour des circuits relativement complexes, et notamment pour des circuits à courant polyphasé, plusieurs piles doivent être mises en oeuvre, conduisant à des poids et volumes relativement importants et à un coût élevé de l'installation.

EP 2 056 441, JP 8 037 198, US 2 936 704 et EP 2 161 745 décrivent des piles de composants électroniques maintenus suivant un empilement pressé comportant :
- des composants électroniques empilés suivant un axe d'empilement ;
- deux brides d'extrémité reliées l'une à l'autre par au moins deux tirants s'étendant parallèlement à l'axe d'empilement des composants, l'empilement des composants étant maintenu pressé entre les deux brides d'extrémité ;
- au moins une bride intermédiaire de reprise des efforts transversaux disposée dans la partie courante de l'empilement de composants et définissant dans l'empilement des empilements élémentaires, la ou chaque bride intermédiaire comportant des alésages de passage des tirants propres à assurer la reprise des efforts transversaux ; et
- en ce qu' une liaison rotule est interposée entre chaque bride intermédiaire et une extrémité d'un empilement élémentaire.

L'invention a pour but de permettre de réduire les poids et volumes d'une installation comportant de nombreux composants électroniques devant être maintenus empilés et pressés.

A cet effet, l'invention a pour objet une pile de composants électroniques maintenus suivant un empilement pressé du type précité, selon la revendiction 1.

Suivant des modes particuliers de réalisation, la pile comporte l'une ou plusieurs des caractéristiques suivantes :
- une liaison rotule est interposée entre chaque extrémité d'un empilement élémentaire et chaque bride intermédiaire,
- la pile comporte un organe élastique de reprise des effets de la dilatation disposé suivant la longueur de la pile entre les deux brides d'extrémité,
- la ou chaque bride intermédiaire est montée coulissante par rapport aux tirants,
- le nombre de composants électroniques empilés entre deux brides d'extrémité ou intermédiaires successives est compris entre 2 et 12 ; et
- l'empilement de composants comporte au moins un élément isolant séparant l'empilement en au moins deux sous-circuits de composants montés en série.

L'invention sera mieux comprise à la lecture de la description qui va suivre, donnée uniquement à titre d'exemple, et faite en se référant aux dessins sur lesquels :
- la figure 1 est un schéma électrique d'un module de puissance formé par une pile selon l'invention ;
- la figure 2 est une vue en perspective de la pile formant le module de puissance de la figure 1 ;
- la figure 3 est une vue de côté de la pile de la figure 2 ;
- la figure 4 est une vue schématique fonctionnelle de la partie mécanique de la pile des figures 2 et 3 ; et
- la figure 5 est une vue identique à celle de la figure 4 d'une variante de réalisation d'une pile selon l'invention.

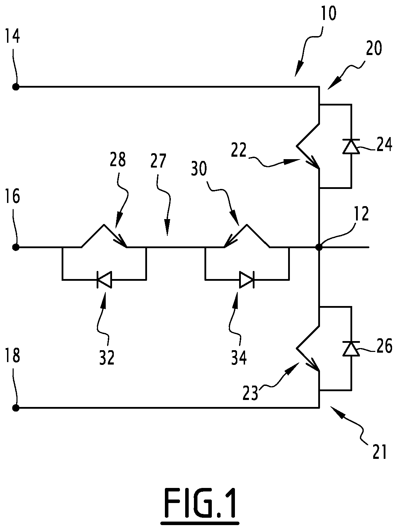

Le circuit illustré sur la figure 1 est une alimentation à trois niveaux réalisée à partir d'un onduleur trois niveaux de type NPP pour «neutral point piloted».

Ce circuit comporte comme connu en soi une entrée 12 pour un courant alternatif d'alimentation et trois sorties 14, 16, 18 respectivement pour une tension positive, une tension nulle et une tension négative. La borne d'entrée 12 est reliée à chacune des bornes 14 et 18 par une branche de commutation 20, 21 respectivement formée chacune de plusieurs organes de commutation 22, 33 en série aux bornes desquels sont montées des diodes 24, 26 en antiparallèle. Ces composants montés en série sont illustrés sur la figure 1 pour chaque branche par un unique transistor et une unique diode. Dans la pratique, ceux-ci sont par exemple au nombre de six pour chaque branche.

Les bornes 12 et 16 sont reliées par une branche de commutation 27 constituée de deux groupes d'organes de commutation 28, 30 reliées en anti-série. Chaque groupe d'organe de commutation est constitué de cinq transistors IGBT montés en série. Des diodes 32, 34 sont montées en antiparallèle sur les groupes d'organes de commutation 28,30.

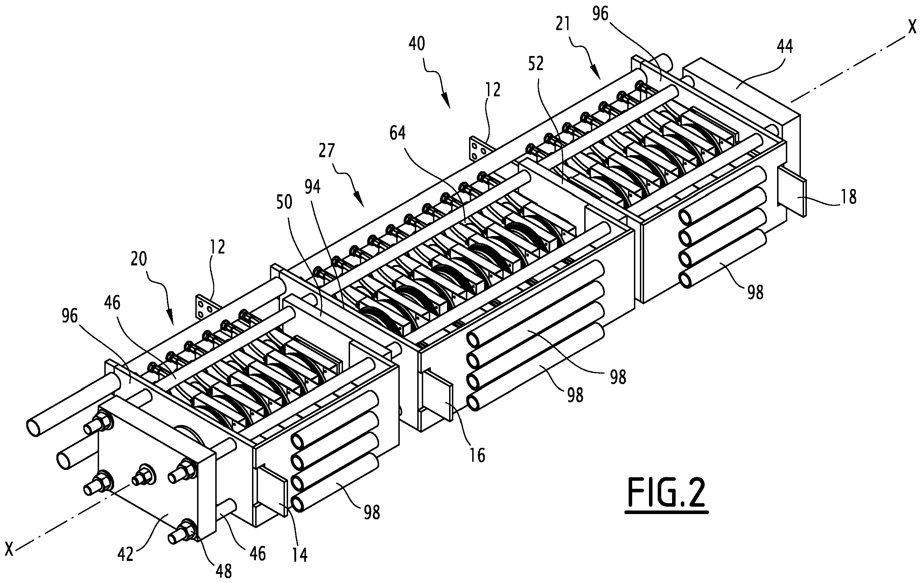

La pile 40, illustrée sur la figure 2 est une forme de réalisation du circuit de la figure 1 On retrouve les bornes 14, 16 et 18, de sortie, ainsi que la borne d'entrée 12 constituée par deux pattes de connexion portant les mêmes numéros de référence.

Entre ces bornes sont formées les branches de commutation 20, 21 et 27. Chaque branche est formée d'un empilement élémentaire de composants électroniques, tels que des composants à semi-conducteurs, désigné par la même référence que la branche du circuit qu'il constitue.

La pile comprend, comme connu en soi, deux brides d'extrémités 42, 44 formées par des plaques métalliques rigides. Elles sont reliées l'une à l'autre par quatre tirants 46. Ces tirants s'étendent suivant un axe longitudinal X-X de la pile perpendiculairement au plan des brides 42, 44. Les tirants sont disposés au coin des brides et délimitent entre eux un espace dans lequel sont disposés les composants électroniques.

Les tirants sont solidaires en rotation à une extrémité de la bride 44 et traversent l'autre bride 42 au travers d'alésage. Ils sont équipés à leur extrémité d'écrous 48 permettant le serrage des brides 42, 44 l'une vers l'autre assurant le pressage des composants disposés entre elles.

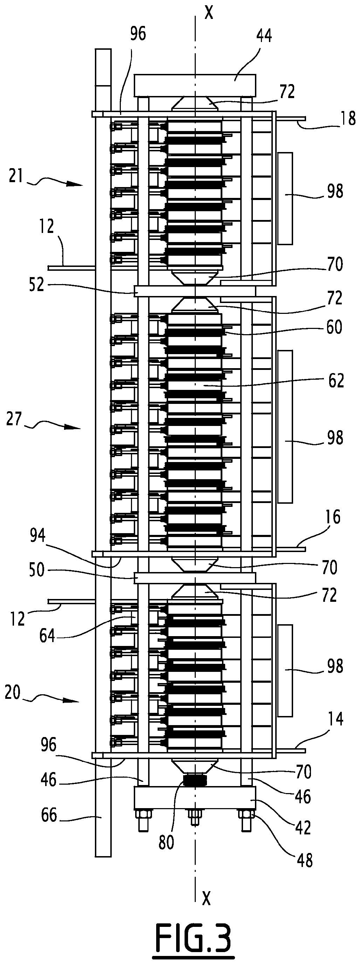

Comme cela est visible sur la figure 3 , les composants des branches de commutation 20, 21 et 27 sont empilés suivant l'axe longitudinal X-X et sont séparés par des brides intermédiaires rigides 50, 52 assurant une reprise d'efforts transversaux sur les tirants 46. Ces brides intermédiaires délimitent les empilements élémentaires. Ces empilements élémentaires sont alignés les uns avec les autres.

Les brides intermédiaires 50, 52 sont formées de plaques rigides conductrices disposées transversalement à l'axe X-X et pourvues d'alésages pour le passage des tirants 46. Les brides intermédiaires sont montées coulissantes par rapport aux tirants 46.

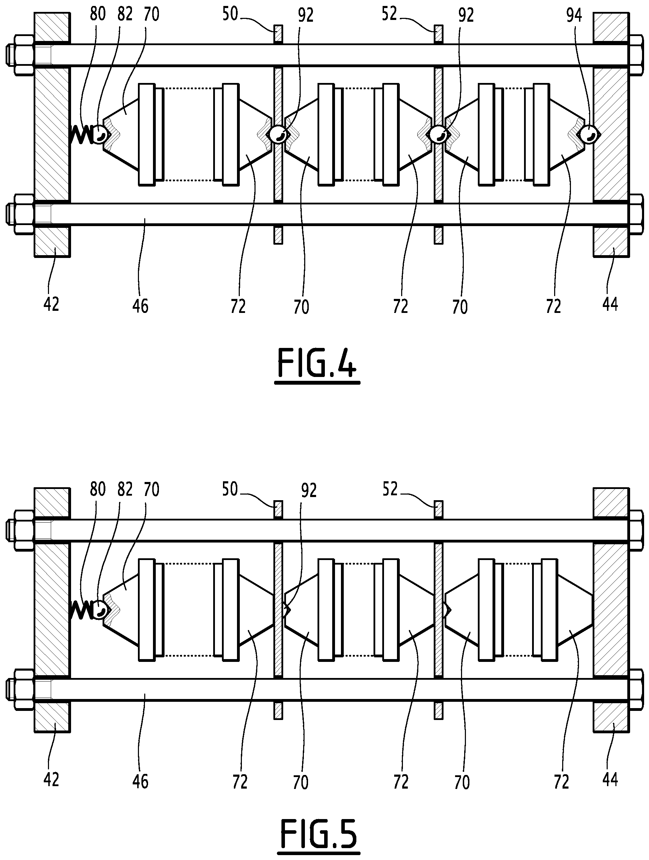

Comme illustré en détail sur les figures 2 et 3 et schématiquement sur la figure 4 , chaque empilement élémentaire, formant une branche 20, 21 ou 27, comporte des composants électroniques désignés par la référence générale 60 renfermant chacun un transistor IGBT monté en anti-parallèle avec une diode. Les composants 60 sont séparés les uns des autres par des refroidisseurs 62. Chaque composant électronique est formé d'une galette cylindrique reliée à un circuit de commande adjacent 64 communément appelé « driver ». Ce dernier est relié à une unité de commande par un faisceau de fils de liaison circulant le long de la pile.

Chaque empilement élémentaire de composants 20, 21, 27 est enserré entre deux cales de répartition d'effort 70, 72 en forme de cône. La surface élargie de ces cales prend appui sur l'empilement de composants alors que l'autre extrémité rétrécie prend appui sur une bride d'extrémité 42, 44 ou une bride intermédiaire 50, 52 adjacente.

Ces cales de répartition d'effort sont propres à permettre une application homogène de l'effort de pression sur toute la section de l'empilement.

Les bornes de liaison 12, 14, 16, 18 sont formées par des plaques interposées entre une extrémité de l'empilement élémentaire associée et la cale de répartition d'effort prévue à l'extrémité de l'empilement élémentaire. Les deux bornes de liaison sont reliées ensemble électriquement par des moyens non représentés.

Dans le mode de réalisation envisagé, la cale 70, adjacente à la bride 42, prend appui sur la bride 42 avec interposition d'un organe élastique 80 de compensation de jeu de l'effet de la dilatation de tout type connu. Cet organe élastique est formé, par exemple, d'un ressort de compression propre à absorber les variations de longueur des empilements dues à la dilatation lors du fonctionnement.

En outre, une liaison rotule 82 est ménagée entre la bride d'extrémité 42 et la cale 70 suivant l'axe X-X.

Cette liaison rotule 82 est assurée, comme connu en soi, par exemple par une portion sphérique disposée suivant l'axe X-X et solidaire radialement de la bride d'extrémité 42, et par un logement tronconique formé suivant l'axe X-X dans la cale 70 dans lequel est reçue la portion sphérique 82.

De même, une liaison rotule 92 est formée entre chaque bride intermédiaire 50, 52 et les deux cales adjacentes 70, 72 comme illustré sur la figure 4 . Une dernière liaison rotule 93 est formée entre la cale extrême 72 de l'empilement élémentaire 21 et la bride d'extrémité 44.

Afin d'assurer la conduction électrique entre les extrémités voisines des empilements 21 et 27, la bride intermédiaire 52 est propre à transmettre le courant électrique entre les cales adjacentes 70 et 72. Une plaque isolante 94 est interposée entre l'empilement élémentaire 27 et la cale 70 pour assurer un isolement électrique entre les extrémités adjacentes des empilements 20 et 27. De même, des isolants 96 sont disposés aux deux extrémités de l'empilement.

Des associations de résistances et de condensateurs 98 sont portées par des supports latéraux visibles sur la figure 2 , lesquels sont fixés sur les tirants longitudinaux 46, comme connu en soi.

On conçoit qu'avec un tel agencement, les brides intermédiaires 50, 52 assurent une reprise des efforts transversaux résultant de l'empilement de longueur constituée par la succession des empilements élémentaires 20, 27 et 21. Ces efforts sont repris sur les tirants longitudinaux 46, réduisant ainsi le flambage de l'empilement. Ainsi, un très grand nombre de composants électroniques de puissance peut être disposé successivement dans le même empilement, que ceux-ci soient ou non reliés en série électriquement.

La présence des liaisons rotules favorise la répartition homogène des pressions dans l'empilement sur toute la section transversale des composants à semi-conducteurs.

Dans le mode de réalisation de la figure 5 , une liaison rotule est prévue seulement à une extrémité de chaque pile élémentaire. Ainsi, une liaison appui plan est prévue à une extrémité de chaque empilement élémentaire prenant appui sur une bride d'extrémité ou une bride intermédiaire et une liaison en rotule est prévue à l'autre extrémité de chaque pile.

Avantageusement, les liaisons appui plan et rotule sont disposées alternativement.

Suivant un mode de réalisation, deux piles ou plus sont connectées électriquement ensemble.

## Revendications

1. Pile (40) de composants électroniques maintenus suivant un empilement pressé comportant :
- des composants (60) électroniques empilés suivant un axe d'empilement (X-X) ;
- deux brides d'extrémité (42, 44) reliées l'une à l'autre par au moins deux tirants (46) s'étendant parallèlement à l'axe d'empilement (X-X) des composants (60), l'empilement des composants étant maintenu pressé entre les deux brides d'extrémité (42, 44) ;
- au moins une bride intermédiaire (50, 52) de reprise des efforts transversaux disposée dans la partie courante de l'empilement de composants (60) et définissant dans l'empilement des empilements élémentaires (20, 21, 27), la ou chaque bride intermédiaire (50, 52) comportant des alésages de passage des tirants (46) propres à assurer la reprise des efforts transversaux ; et
- une liaison rotule (82, 92) étant interposée entre chaque bride intermédiaire (50, 52) et une extrémité d'un empilement élémentaire (20, 21, 27) ;
**caractérisée en ce qu'** elle comporte de part et d'autre de la ou chaque bride intermédiaire (50, 52), une cale (70, 72) de répartition d'effort sur toute la section de l'empilement, laquelle cale est interposée suivant l'axe de la pile (X-X) entre la bride intermédiaire (50, 52) et le composant (60) adjacent de la pile.

2. Pile selon la revendication 1, **caractérisée en ce qu'** une liaison rotule (92) est interposée entre chaque extrémité d'un empilement élémentaire (20, 21, 27) et chaque bride intermédiaire (50, 52).

3. Pile selon la revendication 2, **caractérisée en ce qu'**elle comporte un organe élastique (80) de reprise des effets de la dilatation disposé suivant la longueur de la pile entre les deux brides d'extrémité (42, 44).

4. Pile selon la revendication 2 ou 3, **caractérisée en ce que** la ou chaque bride intermédiaire (50, 52) est montée coulissante par rapport aux tirants (46).

5. Pile selon l'une quelconque des revendications précédentes, **caractérisée en ce que** le nombre de composants électroniques (60) empilés entre deux brides d'extrémité ou intermédiaires successives est compris entre 2 et 12.

6. Pile selon l'une quelconque des revendications précédentes, **caractérisée en ce que** l'empilement de composants (60) comporte au moins un élément isolant (94) séparant l'empilement en au moins deux sous-circuits (20, 21, 27) de composants (60) montés en série.

## Patentansprüche

1. Stapel (40) elektronischer Bauelemente, die durch eine zusammengedrückte Stapelung gehalten sind, aufweisend:
- elektronische Bauelemente (60), die entlang einer Stapelungsachse (X-X) gestapelt sind;
- zwei Endbügel (42, 44), die miteinander über mindestens zwei Zugelemente (46) verbunden sind, die sich parallel zur Stapelungsachse (X-X) der Bauteile (60) erstrecken, wobei die Stapelung der Bauelemente zwischen den beiden Endbügeln (42, 44) zusammengedrückt aufrecht erhalten wird;
- wenigstens ein Zwischenbügel (50, 52) zur Wiederaufnahme von Querkräften, der im laufenden Abschnitt der Stapelung der Bauteile (60) angeordnet ist und in der Stapelung Elementarstapel (20, 21, 27) definiert, wobei der oder jeder Zwischenbügel (50, 52) Durchgangsbohrungen für die Zugelemente (46) aufweist, die dazu eingerichtet sind, die Aufnahme der Querkräfte sicherzustellen; und
- eine Kugelgelenkverbindung (82, 92), die zwischen jedem Zwischenbügel (50, 52) und einem Ende eines Elementarstapels (20, 21, 27) angeordnet ist;
**dadurch gekennzeichnet, dass** er auf beiden Seiten des oder jedes Zwischenbügels (50, 52) ein Stützteil (70, 72) zur Aufteilung der Kraft auf den gesamten Abschnitt der Stapelung aufweist, wobei das Stützteil entlang der Achse des Stapels (X-X) zwischen dem Zwischenbügelr (50, 52) und dem benachbarten Bauelement (60) des Stapels angeordnet ist.

2. Stapel nach Anspruch 1, **dadurch gekennzeichnet, dass** eine Kugelverbindung (92) zwischen jedem Ende eines Elementarstapels (20, 21, 27) und jedem Zwischenbügel (50, 52) angeordnet ist.

3. Stapel nach Anspruch 2, **dadurch gekennzeichnet, dass** er ein elastisches Element (80) zur Aufnahme von Dehnungseffekten aufweist, das entlang der Länge des Stapels zwischen den zwei Endklammern (42, 44) angeordnet ist.

4. Stapel nach Anspruch 2 oder 3, **dadurch gekennzeichnet, dass** der oder jeder Zwischenbügel (50, 52) verschiebbar gegenüber den Zugelementen (46) angebracht ist.

5. Stapel nach irgendeinem der vorhergehenden Ansprüche, **dadurch gekennzeichnet, dass** die Anzahl der elektronischen Bauelemente (60), die zwischen den beiden Endklammern oder aufeinanderfolgenden Zwischenklammern gestapelt sind, zwischen 2 und 12 beträgt.

6. Stapel nach irgendeinem der vorhergehenden Ansprüche, **dadurch gekennzeichnet, dass** die Stapelung der Bauelemente (60) wenigstens ein Isolationselement (94) aufweist, das die Stapelung in wenigstens zwei Unterschaltkreise (20, 21, 27) der in Reihe angeordneten Bauelemente (60) unterteilt.

## Claims

1. Stack (40) of electronic components held in a pressed stack, comprising:
- electronic components (60) stacked along a stacking axis (X-X);
- end flanges (42, 44) connected to each other by at least two tie rods (46) extending parallel to the stacking axis (X-X) of the components (60), the stack of components behind held pressed between the two end flanges (42, 44);
- at least one intermediate flange (50, 52) for absorbing transverse forces, arranged in the current part of the stack of components (60) and defining elementary stacks (20, 21, 27) in the stack, the or each intermediate flange (50, 52) comprising holes for passage of the tie rods (46) and able to ensure absorption of the transverse forces; and
- a ball joint (82, 92) interposed between each intermediate flange (50, 52) and an end of the elementary stack (20, 21, 27);
**characterised in that** it comprises, on either side of the or each intermediate flange (50, 52), a shim (70, 72) for distributing the force over the entire cross-section of the stack, said shim being interposed in the axis of the stack (X-X) between the intermediate flange (50, 52) and the adjacent component (60) of the stack.

2. Stack according to claim 1, **characterised in that** a ball joint (92) is interposed between each end of an elementary stack (20, 21, 27) and each intermediate flange (50, 52).

3. Stack according to claim 2, **characterised in that** it comprises an elastic body (80) for absorbing expansion effects, arranged along the length of the stack between the two end flanges (42, 44).

4. Stack according to claim 2 or 3, **characterised in that** the or each intermediate flange (50, 52) is mounted so as to slide relative to the tie rods (46).

5. Stack according to any of the preceding claims, **characterised in that** the number of electronic components (60) stacked between two successive end or intermediate flanges is between 2 and 12.

6. Stack according to any of the preceding claims, **characterised in that** the stack of components (60) comprises at least one isolating element (94) separating the stack into at least two sub-circuits (20, 21, 27) of components (60) mounted in series.
